# EUROPÄISCHE PATENTSCHRIFT

(11) **EP 0 969 495 B1**
(45) Veröffentlichungstag und Bekanntmachung des Hinweises auf die Patenterteilung: **18.04.2012**
(21) Anmeldenummer: 99109886.4
(22) Anmeldetag: 20.05.1999
(51) Int. Cl.: H01J 37/244, H01J 37/28

(54) **Teilchenstrahlgerät mit Sekundärelektronen-Detektor**
Particle beam apparatus with secondary electron detector
Appareil à faisceau de particules avec détecteur d'électrons secondaires

(30) Priorität: 26.06.1998 DE 19828476
(43) Veröffentlichungstag der Anmeldung: 05.01.2000
(73) Patentinhaber: Carl Zeiss NTS GmbH, 73447 Oberkochen (DE)
(72) Erfinder: Weimer, Eugen, Dr., 73457 Essingen (DE); Drexel, Volker, 89551 Königsbronn (DE)
(74) Vertreter: Gnatzig, Klaus

(56) Entgegenhaltungen:
- EP-A- 0 490 154
- EP-A- 0 769 799
- WO-A-99/46797
- US-A- 5 466 940
- US-A- 5 894 124
- KHURSHEED A: "HIGH SPEED ELECTRON-BEAM TESTING OF VLSI CIRCUITS BY BACKSCATTERED ELECTRON DETECTION" ELECTRONICS LETTERS, Bd. 26, Nr. 20, 27. September 1990 (1990-09-27), Seiten 1657-1658, XP000109541 ISSN: 0013-5194

## Beschreibung

Teilchenstrahlgeräte mit Ionen oder Elektronen werden bevorzugt zur Abbildung, Analyse und Bearbeitung von Probenoberflächen eingesetzt. Zur Bilderzeugung wird ein fokussierter Teilchenstrahl rasterförmig über die Probenoberfläche geführt und die bei der Wechselwirkung der Primärteilchen mit der Probe entstehenden Signale werden erfaßt und dem jeweiligen Entstehungsort zugeordnet. Neben einer hohen Ortsauflösung, die durch einen geringen Durchmesser des Teilchenstrahls in der Ebene der Probe erreicht wird, ist eine möglichst hohe Effizienz der Detektion der verschiedenen Signale erforderlich.

Die Auflösung von Korpuskularstrahlgeräten ist prinzipiell am besten, wenn sich die Probe sehr nahe an der Objektivlinse oder sogar innerhalb dieser Linse befindet. Dieses hat zur Folge, daß das Detektionssystem zum Nachweis von sekundär- und/oder rückgestreuten Teilchen innerhalb der Objektivlinse oder in einem feldfreien Bereich zwischen der Objektivlinse und der Teilchenquelle angeordnet sein muß. Die beste Auflösung, insbesondere bei niedrigen Teilchenenergien, wird mit Anordnungen erzielt, bei der die Teilchen im Strahlerzeugungssystem zunächst auf eine hohe Energie beschleunigt und am Ende der teilchenoptischen Anordnung in einer Objektivlinse oder im Bereich zwischen der Objektivlinse und der Probe auf die gewünschte Endenergie abgebremst werden.

Entsprechende Teilchenstrahlgeräte sind beispielsweise in der US-A 4,831,266 und der US-A 4,926,054 beschrieben. Durch Kombination eines elektrostatischen und eines magnetischen Feldes in der Objektivlinse wird selbst bei niedrigen Teilchenenergien eine sehr hohe Auflösung erzielt. Darüberhinaus werden die von der Probe zurückgestreuten oder anderweitig von der Probe emittierten Teilchen in entgegengesetzter Richtung vom elektrostatischen Feld beschleunigt und auf einen ringförmigen Szintillationsdetektor oberhalb der Objektivlinse abgebildet. In der US 4,896,036 ist eine ähnliche Anordnung mit einem ebenfalls ringförmigen Detektor beschrieben, bei der allerdings die Objektivlinse eine rein elektrostatische Linse ist.

Bei diesen bekannten Systemen hat es sich als nachteilig herausgestellt, daß der ringförmige Detektor mit Szintillator- und Glaslichtleiter eine relativ große Öffnung von ca. 2-3 mm aufweisen muß, damit der Primärteilchenstrahl nicht vom ringförmigen Detektor behindert wird. Rechnungen und Experimente haben ergeben, daß durch die zentrale Öffnung des Detektors bis zu etwa 80 % der an der Probe entstehenden Teilchen hindurchtreten und damit nicht detektiert werden. Das detektierte Signal ist dadurch sehr schwach. Außerdem werden die detektierten Teilchen nur integral erfaßt, und können demzufolge nicht nach Energie und Startwinkel separiert werden.

Aus einem Aufsatz in Nuclear Instruments & Methods in Physics Research A, Volium 363, Seiten 31-42, (1995) ist es bekannt, durch geeignete Anordnung zweier Wien-Filter, die von der Probe emittierten oder an der Probe zurückgestreuten Teilchen in achsenferne Bereiche zu lenken, ohne daß der Primärteilchenstrahl merklich beeinflußt wird. Diese Maßnahme führt zwar zu einer Verbesserung der Detektionseffizient, eine Unterscheidung der detektierten Signale nach Startwinkel usw. ist jedoch auch hier nicht möglich.

In der US-A 5,644,132 ist ein Rasterelektronenmikroskop beschrieben, bei dem der ringförmige Detektor mehrere ringförmige Unterteilungen aufweist. Durch diese Aufteilung sollen die an der Probe zurückgestreuten Elektronen, die im Vergleich zu den Sekundärelektronen schwerpunktsmäßig stärker im achsnahen Bereich nachweisbar sind, von den achsferneren Sekundärelektronen separiert werden. Im Zusammenhang mit einem Ausführungsbeispiel ist dabei auch die Möglichkeit angesprochen, daß aus Montagegründen der innere ringförmige Detektor und der äußere ringförmige Detektor leicht versetzt in Richtung der optischen Achse angeordnet werden können. Eine solche ringförmige Aufteilung des Detektors erlaubt zwar grundsätzlich eine Separierung der detektierten Elektronen nach deren Startwinkel beim Austritt aus der Probe. Das Problem, daß ein großer Anteil der Sekundärelektronen und der zurückgestreuten Elektronen durch den zentralen Bohrungsbereich transmittiert und demzufolge überhaupt nicht nachgewiesen wird, läßt sich durch diese ringförmige Unterteilung des Detektors jedoch nicht lösen.

Es ist das Ziel der vorliegenden Erfindung, bei einem Teilchenstrahlgerät die Detektion der von der Probe emittierten Sekundärteilchen und der an der Probe zurückgestreuten Teilchen zu verbessern. Darüberhinaus sollte eine Selektion oder Zuordnung der detektierten Teilchen nach deren Startwinkel möglich sein.

Aus der US-A-4 896 036 ist ein Teilchenstrahlapparat mit den Merkmalen des Oberbegriffs des Anspruchs 1 bekannt.

Dieses Ziel wird erfindungsgemäß durch ein Teilchenstrahlgerät mit den Merkmalen des Anspruches 1 gelöst. Vorteilhafte Ausgestaltungen der Erfindung ergeben sich aus den Merkmalen der abhängigen Ansprüche.

Beim erfindungsgemäßen Teilchenstrahlgerät sind zwei Detektoren für die vom Objekt zurückgestreuten oder vom Objekt emittierten Teilchen in Richtung der optischen Achse des Teilchenstrahlgerätes zueinander versetzt angeordnet. Der Abstand in Richtung der optischen Achse zwischen beiden Detektoren beträgt dabei zwischen 50 und 75% des Abstandes zwischen dem objektseitigen Detektor und der Fokusebene des Objektivs, durch das der Teilchenstrahl auf die Probe fokussiert wird. Der probenseitige Detektor dient dabei zur Detektion derjenigen Teilchen, die unter einem relativ großen Raumwinkel aus der Probe austreten, während der quellenseitige Detektor zur Detektion derjenigen Teilchen dient, die unter einem relativ geringen Raumwinkel aus der Probe austreten und durch die für den Durchtritt des Primärteilchenstrahls durch den probenseitigen Detektor vorgesehene Öffnung durch diesen transmittieren. Durch die achsial versetzte Anordnung beider Detektoren können mit dem quellenseitigen Detektor sogar dann durch die zentrale Bohrung des objektseitigen Detektors transmittierte Teilchen nachgewiesen werden, wenn beide Detektoren zentrale Öffnungen mit gleichen Durchmesser aufweisen. Vorzugsweise sollte jedoch die zentrale Öffnung für den Durchtritt des Primärteilchenstrahls beim quellenseitigen Detektor höchstens ein Drittel des Durchmessers der zentralen Bohrung des objektseitigen Detektors betragen. Entsprechend kleine Bohrungsdurchmesser von beispielsweise unter 0,2 mm durch den quellenseitigen Detektor sind dann möglich, wenn dieser Detektor als Konversionsblende ausgebildet ist, an der beim Auftreffen hochenergetischer Teilchen selbst wieder Sekundärelektronen entstehen. Die aus der Konversionsblende austretenden Sekundärelektronen werden dann durch einen seitlich angeordneten konventionellen Detektor, der ein elektrostatisches Absaugfeld für die aus der Konversionsblende austretenden Sekundärelektronen erzeugt, detektiert. Das Material der Konversionsblende sollte ein relativ leichtes Element mit einer Ordnungszahl < = 20 sein, z.B. Aluminium oder Kohlenstoff, da solche leichten Elemente eine relativ hohe Sekundärelektronen-Ausbeute aufweisen.

Wie bei dem eingangs genannten Stand der Technik weisen beide Detektoren eine symmetrisch zur optischen Achse ausgebildete, ringförmige Detektionsfläche auf. Im Unterschied zum eingangs genannten Stand der Technik sollte jedoch der Außendurchmesser der Detektionsfläche des quellenseitigen Detektors größer als der Durchmesser der zentralen Bohrung des probenseitigen Detektors sein.

Soweit der quellenseitige Detektor nur eine sehr kleine, die Apertur des Primärstrahls begrenzende Bohrung für den Durchtritt des Primärstrahls aufweist, sollte dieser Detektor an einer Justiervorrichtung aufgenommen sein, die eine Justierung des Detektors in den beiden zur optischen Achse senkrechten Richtungen erlaubt.

Für die Auswertung der mit beiden Detektoren detektierten Signale kann eine Signalverarbeitungselektronik vorgesehen sein, die aus den Detektorsignalen Ausgangssignale erzeugt, die Linearkombinationen beider Detektorsignale entsprechen. Durch Bildung entsprechender Linearkombinationen können die Einflüsse der Oberflächen-Topographie der Probe verstärkt und Ladungskontrastbilder erzeugt werden. Dieses ist insbesondere dann von Vorteil, wenn dünne Schichten mit zur Matrix unterschiedlicher Leitfähigkeit im Teilchenstrahlgerät untersucht werden. Die Koeffizienten der Linearkombinationen sollten dabei vom Benutzer des Teilchenstrahlgerätes frei wählbar sein.

Nachfolgend werden Einzelheiten der Erfindung anhand des in den Figuren dargestellten Ausführungsbeispiels für ein Rasterelektronenmikroskop näher erläutert.

Im einzelnen zeigen:
- Figur 1: die Prinzipskizze eines Rasterelektronenmikroskops im Schnitt, in dem die Erfindung realisiert ist; und
- Figur 2: ein Diagramm der Elektronenbahnen für Sekundärelektronen in Abhängigkeit vom Startwinkel an der Probenoberfläche.

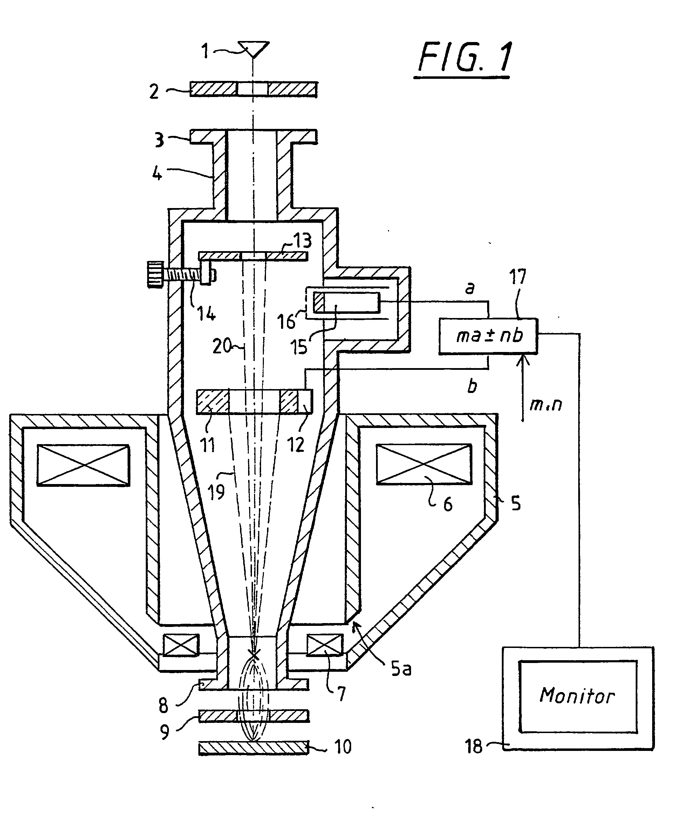

Der Teilchenstrahlerzeuger beim erfindungsgemäßen Teilchenstrahlgerät besteht aus einer die Teilchen emittierenden Kathode (1), einer Extraktionselektrode (2) und einer Anode (3). Ist das erfindungsgemäße Teilchenstrahlgerät als Rasterelektronenmikroskop ausgebildet, ist die Kathode (1) vorzugsweise ein thermischer Feldemitter. Die aus der Kathode (1) austretenden Teilchen werden durch die in der Figur 1 nicht dargestellte Potentialdifferenz zwischen der Kathode (1) und der Anode (3) auf das Anodenpotential beschleunigt.

Die Anode (3) bildet gleichzeitig das quellenseitige Ende des Strahlführungsrohres (4). Dieses Strahlführungsrohr (4) aus elektrisch leitendem Material ist durch die Bohrung durch die Polschuhe (5) einer als Objektiv wirkenden Magnetlinse geführt und ist am objektseitigen Ende (8) als Rohrlinse verdickt ausgebildet. Dieses verdickte objektseitige Ende des Strahlführungsrohres (4) endet erst hinter dem Polschuhspalt (5a) der Magnetlinse, deren Spulen mit (6) bezeichnet sind. Dem Strahlführungsrohr nachgeordnet ist eine Einzelelektrode (9), die gemeinsam mit der Rohrelektrode (8) des Strahlführungsrohres (4) eine elektrostatische Verzögerungseinrichtung bildet. Die Rohrelektrode (8) liegt gemeinsam mit dem gesamten Strahlführungsrohr (4) auf dem Anodenpotential, während die Einzelelektrode (9) und die Probe (10) auf einem gegenüber dem Anodenpotential niedrigeren Potential liegen, so daß die Teilchen nach Austritt aus dem Strahlführungsrohr auf die gewünschte niedrigere Energie abgebremst werden.

In der Bohrung des Polschuhs (5) der Objektivlinse, in Höhe des Polschuhspaltes (5a) ist noch ein Ablenksystem (7) angeordnet, durch das der durch das Objektiv (5) auf die Probe (10) fokussierte Primärelektronenstrahl senkrecht zu der strichpunktiert-dargestellten optischen Achse zum Abrastern der Probe (10) abgelenkt wird.

Insoweit wie gerade beschrieben, hat das in Figur 1 dargestellte Rasterelektronenmikroskop einen Aufbau, wie dieser in der deutschen Patentanmeldung 197 32 093.7 beschrieben ist. Auf diese frühere Anmeldung sei auch bezüglich der Potentialbeaufschlagung von Kathode (1), Extraktionselektrode (2), Anode (3) und Bremselektrode (9) verwiesen.

Alternativ zu der Darstellung in Figur 1 kann das Strahlführungsrohr (4) auch auf Höhe des Polschuhspaltes (5a) enden und die Abremselektrode (9) auch in etwa in Höhe des Polschuhspaltes (5a) angeordnet sein. Die Abbremsung der Primärteilchen auf die gewünschte Auftreffenergie erfolgt dann bereits innerhalb des Objektivs, so daß sich das magnetische Feld der Objektivlinse und das elektrostatische Verzögerungsfeld räumlich überlagern.

Zur Detektion der aus der Probe (10) austretenden Teilchen, der zurückgestreuten Elektronen und der Sekundärelektronen, sind innerhalb des Strahlführungsrohres (4) zwischen dem Strahlerzeuger und dem Objektiv (5, 6) zwei Detektoren in Richtung der optischen Achse zueinander versetzt angeordnet. Beide Detektoren haben eine ringförmige, im wesentlichen symmetrisch zur optischen Achse angeordnete Detektionsfläche. Der objektseitige Detektor ist dabei in bekannter Weise als Szintillator mit einem Glaslichtleiter (11) und einem optischen Detektor (12) ausgebildet. Der Glaslichtleiter (11) dient dabei zur Konversionen der auftreffenden Elektronen in Photonen und gleichzeitig zur Leitung der Photonen zum optischen Detektor (12). Da der Glaslichtleiter für eine hohe Effizienz der Lichtleitung eine relativ große Dicke in Richtung der optischen Achse von ca. 5-7 mm aufweist, weist die Bohrung durch den Glaslichtleiter für den Durchtritt des Primärstrahls einen Durchmesser von 2-3 mm auf, damit der Primärstrahl durch den Glaslichtleiter nicht beeinflußt wird. Der probenseitige Detektor (11, 12) dient zur Detektion derjenigen Teilchen, die unter einem relativ großen Raumwinkel aus der Probe (10) austreten. Dabei handelt es sich in erster Linie um Sekundärelektronen, deren kinetische Energie beim Austritt aus der Probe (10) im Bereich zwischen 1-50 eV mit einem Maximum bei 2-4 eV liegt. An der Probe (10) zurückgestreute Elektronen, die im Vergleich zu den Sekundärelektronen eine relativ hohe kinetische Energie beim Austritt aus der Probe (10) aufweisen, werden dagegen vom Detektor (11) nur zu einem sehr geringen Anteil erfaßt. Denn die relativ zur optischen Achse in einem Raumwinkel von 0-5° aus der Probe austretenden zurückgestreuten Elektronen transmittieren durch das Loch durch den Detektor (11) und die unter einem Winkel von > 15° aus der Probe austretenden Elektronen treffen bereits im Polschuhbereich auf das Strahlführungsrohr (4) und werden dort absorbiert.

Der quellenseitige Detektor enthält eine ringförmige Konversionsblende (13), die vom probenseitigen Detektor (11) deutlich in Richtung der optischen Achse beabstandet an einer Justiereinrichtung (14) aufgenommen ist. Durch die Justiereinrichtung (14) ist die Konversionsblende (13) in den beiden Richtungen senkrecht zur optischen Achse justierbar. Die Konversionsblende ist eine dünne Platte mit einer Dicke von 0,1-1 mm aus einem Material mit kleiner Ordnungszahl und hat ein kleines zentrales Loch für den Durchtritt des Primärelektronenstrahls, wobei der Lochdurchmesser etwa 200-400 µm beträgt. Aufgrund des geringen Lochdurchmessers wirkt die Konversionsblende (13) aperturbegrenzend für den Primärelektronenstrahl und wirkt damit gleichzeitig als Aperturblende.

Die Konversionsblende besteht aus einem Material mit geringer Ordnungszahl, beispielsweise Aluminium, so das mit recht hoher Effizienz auf die Konversionsblende (13) auftreffende Elektronen wiederum Sekundärelektronen auslösen. Für die Detektion dieser von der Konversionsblende ausgelösten Sekundärelektronen ist probenseitig der Konversionsblende (13) seitlich von der optischen Achse ein Everhart Thornley Detektor (15) angeordnet. Dieser Everhart Thornley Detektor liegt über eine Gitterelektrode auf einem Potential, das etwa 6-10 kV höher als das auf Anodenpotential liegende Potential der Konversionsblende (13) ist. Durch diese Potentialdifferenz werden die aus der Konversionsblende (13) austretenden Sekundärelektronen in Richtung auf den Detektor (15) abgesaugt und beschleunigt.

Der Abstand entlang der optischen Achse zwischen der Detektionsebene des probenseitigen Detektors (11) und der Konversionsblende (13) beträgt mindestens 25 %, vorzugsweise etwa 50-75 % des Abstandes zwischen der Detektionsfläche des probenseitigen Detektors (11) und der Probe (10). Der äußere Durchmesser der Konversionsblende (13) ist gleichzeitig größer als der Durchmesser der Öffnung durch den probenseitigen Detektor (11). Durch diese geometrische Anordnung ist gewährleistet, daß ein Großteil der aus der Probe (10) austretenden und durch die Öffnung des probenseitigen Detektors (11) transmittierenden Elektronen (20) vom quellenseitigen Detektor (13) detektiert werden.

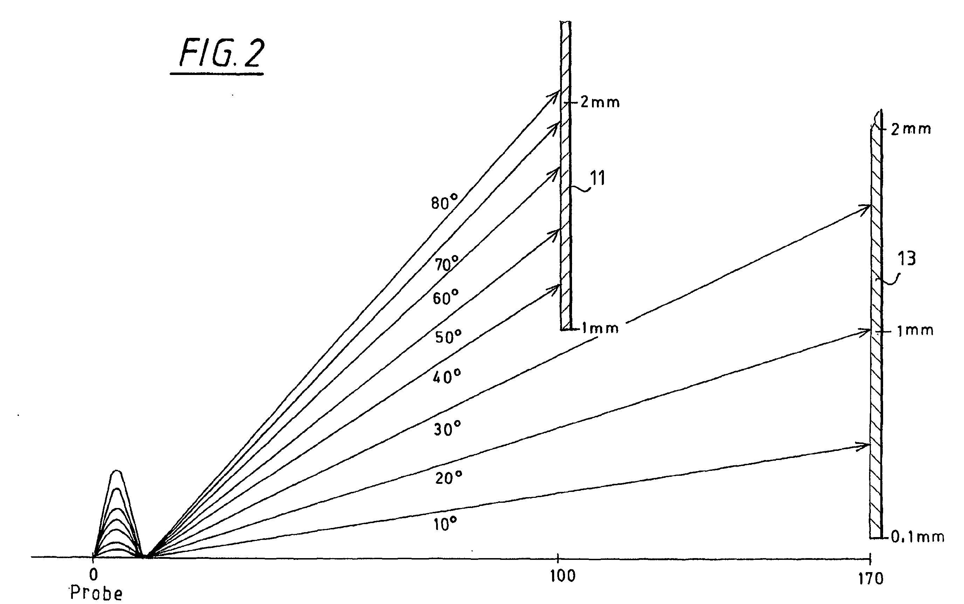

Die mit den zwei in Richtung der optischen Achse versetzt angeordneten Detektoren erzielte Wirkung ist anhand der Figur 2 veranschaulicht. Dort sind die Bahnen für aus der Probe unter unterschiedlichen Winkeln austretende Sekundärelektronen mit einer kinetischen Energie von 3 eV beim Austritt aus der Probe für den Fall aufgetragen, daß die Energie des Primärteilchenstrahls beim Auftreffen auf der Probe 1 keV und der Abstand zwischen der Probe und der Objektivlinse 5 mm beträgt. Zur besseren Veranschaulichung ist der Abstand der Elektronenbahnen von der optischen Achse um einen Faktor 50 überhöht und die Bahn der Elektronen nach deren Schnitt mit der optischen Achse gespiegelt dargestellt. Der Abstand zwischen der Detektionsebene des probenseitigen Detektors (11) und der Probe beträgt 100 mm. Der Radius der zentralen Öffnung durch den probenseitigen Detektor (11) beträgt 1 mm. Wie sich aus dem Diagramm der Bahnverläufe ergibt, werden mit dem probenseitigen Detektor (11) lediglich solche Sekundärelektronen detektiert, die unter einem Winkel von > etwa 35° aus der Probe (10) austreten. Bei einer leitenden Probe (10) mit ebener Probenoberfläche sind die verschiedenen möglichen Startwinkel beim Austritt aus der Probe entsprechend einer Lambert'schen Kosinusverteilung verteilt. Daraus ergibt sich, daß etwa 40 % der aus der Probe austretenden Sekundärelektronen beim Austritt aus der Probe einen Winkel relativ zur optischen Achse von unter 30° aufweisen, so daß etwa 40 % der aus der Probe austretenden Sekundärelektronen vom probenseitigen Detektor nicht erfaßt werden können. Im Falle einer nichtleitenden Probenoberfläche werden in der Praxis infolge von lokalen Aufladungseffekten fast alle Elektronen mit sehr kleinen Winkeln zur Oberflächennormalen emittiert, so daß in diesem in der Praxis sehr wichtigen Fall sogar nur weniger als 20 % der aus der Probe austretenden Sekundärelektronen mit dem probenseitigen Detektor (11) nachgewiesen werden können.

Ein Großteil der durch die Öffnung des probenseitigen Detektors (11) transmittierten Sekundärelektronen wird bei der Anordnung gemäß der Erfindung vom quellenseitigen Detektor (13) nachgewiesen. Dieser quellenseitige Detektor (13) weist in der Figur 2 einen Abstand von 70 mm zur Detektionsebene des probenseitigen Detektors (11) auf. Der Durchmesser des quellenseitigen Detektors (13) bzw. dessen Detektionsfläche ist dabei größer als der Durchmesser der zentralen Öffnung im probenseitigen Detektor (11). Außerdem weist der quellenseitige Detektor (13) nur eine sehr kleine zentrale Öffnung mit einem Radius von 0,1 mm auf, so daß diese Detektorblende für den Primärteilchenstrahl aperturbegrenzend wirkt.

Wie den Bahnverläufen in Figur 2 entnehmbar ist, können mit dem quellenseitigen Detektor auch solche Sekundärelektronen nachgewiesen werden, die unter einem Winkel von unter 35 % aus der Probe austreten. Faßt man die mit beiden Detektoren (11, 13) insgesamt erfaßten Sekundärelektronen zusammen, so ergibt sich, daß bei der erfindungsgemäßen Anordnung der Detektoren sämtliche Sekundärelektronen erfaßt werden, die unter einem Winkel von > 2-3° aus der Probe austreten. Der Signalgewinn durch den zweiten, quellenseitigen Detektor gegenüber derselben Anordnung mit nur dem probenseitigen Detektor beträgt im Falle einer leitenden ebenen Probenoberfläche etwa 40 % und im Falle nichtleitender Probenoberflächen bis zu 80 %.

Darüberhinaus können durch geeignete Mischung, insbesondere der Summen- und Differenzbildung der Ausgangssignale beider Detektoren (11, 13) die Oberflächen-Topographie verstärkt und ein Ladungskontrast erzeugt werden. Für diese Mischung der beiden Detektorsignale (a, b) weist das Teilchenstrahlgerät in Figur 1 eine Signalverarbeitung (17) auf, die beliebig vorgebbare Linearkombinationen beider Detektorsignale (a, b) bildet. Die Koeffizienten der Linearkombination sind dabei seitens des Benutzers beliebig vorgebbar, was in der Figur 1 durch den Pfeil mit den kleinen Buchstaben (m, n) angedeutet ist. Das Ausgangssignal der Signalverarbeitung (17) wird nachfolgend als Funktion des Ortes auf der Probe (10) auf einem Monitor (18) dargestellt oder für eine weitergehende Bildverarbeitung in einem nicht dargestellten Bildspeicher abgelegt.

Besonders nützlich ist die beschriebenen Anordung mit zwei in Richtung der optischen Achse deutlich versetzt angeordneten ringförmigen Detektoren, von denen der probenfernere nur eine sehr kleine zentrale Öffnung aufweist, in Fällen in denen die Primärenergie der Elektonen von mittleren Energien über 5 keV bis hinunter zu niedrigsten Primärenergien unter 200 eV beim Auftreffen auf der Probe variierbar ist. Denn es hat sich gezeigt, daß bei Primärenergien unter 200 eV, insbesondere im Primärenergiebereich 20-100 eV, ein sehr großer Anteil der Sekundärelektronen unabhängig von ihrem Austrittswinkel aus der Probe durch das Objektiv so abgelenkt werden, daß ihre Bahnen im Bereich des probenseitigen Detektors sehr nahe an der optischen Achse verlaufen und deshalb mit diesem Detektor nicht nachweisbar sind. Diese Sekundärelektronen werden mit dem quellenseitigen Detektor effizient detektiert. Gleichzeitig ermöglicht der probenseitige Detektor bei höheren Primärenergien den Nachweis derjenigen Sekundärelektronen, die unter einem großen Winkel relativ zur optischen Achse aus der Probe austreten.

Die Erfindung ermöglicht nicht nur eine Separierung der Sekundärelektronen nach deren Austrittswinkel aus der Probe sondern auch eine Separierung nach deren Energie beim Austritt aus der Probe. Denn da die Bahnen der niederenergetischen Sekundärelektronen unabhängig von deren Austrittswinkel näher an der optischen Achse verlaufen als die Bahnen der höherenergetischen Sekundärelektronen, werden mit dem quellenseitigen Detektor in erster Linie niederenergetische und mit dem probenseitigen Detektor in erster Linie höherenergetische Sekundärelektronen nachgewiesen.

Anhand des in den Figuren dargestellten Ausführungsbeispiels wurde die Erfindung für den Fall erläutert, daß die Primärteilchen Elektronen sind. Bei Anwendung der Erfindung auf positiv geladenen Teilchen braucht lediglich die Polung der verschiedenen Potentiale auf das geänderte Vorzeichen der Teilchenladung angepaßt zu werden.

Weiterhin muß das Objektiv nicht zwingend als Magnetlinse ausgebildet sein. Es ist auch denkbar und insbesondere bei Verwendung schwerer Korpuskeln wie Ionen als Primärteilchen vorteilhaft, für die Fokussierung der Korpuskeln eine elektrostatische Einzellinse einzusetzen. Eine solche elektrostatische Einzellinse kann in bekannter Weise aus drei aufeinanderfolgenden Elektroden aufgebaut sein, von denen die beiden äußeren Elektroden auf dem Potential des Strahlführungsrohres liegen und die mittlere Elektrode dann auf einem Potential das bezüglich der Polarität dem Kathodenpotential entspricht, jedoch betragsmäßig etwas kleiner ist. Eine solche elektrostatische Einzellinse führt im Gegensatz zur elektrostatischen Immersionslinse zu keiner Änderung der Teilchenenergie.

Desweiteren kann das Teilchenstrahlgerät auch weitere teilchenoptische Abbildungselemente aufweisen, wie z.B. einen zwischen der Teilchenquelle und dem quellenseitigen Detektor angeordneten, ein- oder mehrstufigen Kondensor zur Variierung der Sondengröße auf der Probe oder der Apertur des Teilchenstrahls.

## Patentansprüche

1. Teilchenstrahlgerät, insbesondere Elektronenstrahlgerät, mit einem Strahlerzeuger (1, 2, 3), einer Objektivlinse (5, 5a, 6) zur Fokussierung eines Teilchenstrahls auf eine Probe (10) und zwei zwischen dem Strahlerzeuger und der Fokusebene des Objektivs (5, 5a, 6) angeordneten Detektoren (11, 12, 13, 15, 16) für vom Objekt (10) zurückgestreute oder emittierte Teilchen (19, 20), wobei die Detektoren (11, 12, 13, 15, 16) in Richtung der optischen Achse von einander versetzt angeordnet sind und wobei eine elektrostatische Verzögerungseinrichtung vorgesehen ist, durch die die Energie beim Auftreffen auf dem Objekt variierbar ist, **dadurch gekennzeichnet, dass** der Abstand zwischen beiden Detektoren zwischen 50 und 75 % des Abstandes zwischen dem objektseitigen Detektor (11, 12) und der Fokusebene des Objektivs beträgt, und dass durch die elektrostatische Verzögerungseinrichtung die Energie der Elektronen von einer Primärenergie oberhalb 5 keV bis hinunter zu einer niedrigsten Primärenergie unter 200 eV beim Auftreffen auf dem Objekt variierbar ist.

2. Teilchenstrahlgerät nach der Anspruch 1, wobei der Außendurchmesser der teilchenempfindlichen Fläche des quellenseitigen Detektors (13, 15, 16) größer als der Durchmesser der zentralen Bohrung des probenseitigen Detektors (11, 12) ist.

3. Teilchenstrahlgerät nach Anspruch 1 oder 2, wobei beide Detektoren eine symmetrisch zur optischen Achse angeordnete, ringförmige Detektionsfläche (11, 13) aufweisen.

4. Teilchenstrahlgerät nach einem der Ansprüche 1 - 3, wobei die zentrale Öffnung für den Durchtritt des Primärstrahls durch den quellenseitigen Detektors (13, 15, 16) höchstens ein Drittel der zentralen Öffnung des objektseitigen Detektors (11, 12) beträgt.

5. Teilchenstrahlgerät nach einem der Ansprüche 1-4, wobei der quellenseitige Detektor (13, 15, 16) als Konversionsblende (13) mit einem Szintillationsdetektor (15, 16) ausgebildet ist, und wobei der Szintillationsdetektor (15, 16) ein Absaugfeld für aus der Konversionsblende (13) austretende geladene Teilchen aufweist.

6. Teilchenstrahlgerät nach Anspruch 5, wobei die Konversionsblende (13) aus einem Material mit einer Ordnungszahl von höchstens 20 besteht.

7. Teilchenstrahlgerät nach Anspruch 5 oder 6, wobei die Konversionsblende (13) an einer Justiervorrichtung (14) aufgenommen ist.

8. Teilchenstrahlgerät nach einem der Ansprüche 1-7, wobei für die Ausgangssignale beider Detektoren (11, 12, 13, 15, 16) eine Signalverarbeitung (17) vorgesehen ist, die aus den Detektorsignalen Ausgangssignale erzeugt, die Linearkombinationen beider Detektorsignale entsprechen, und wobei die Koeffizienten (m, n) der Linearkombination vom Benutzer frei wählbar sind.

## Claims

1. Particle beam device, more particularly electron beam device, with a beam generator (1, 2, 3), an objective lens (5, 5a, 6) for focussing a particle beam onto a sample (10) and two detectors (11, 12, 13, 15, 16), arranged between the beam generator and the focus plane of the objective (5, 5a, 6), for particles (19, 20) back-scattered or emitted by the object (10), the detectors (11, 12, 13, 15, 16) being arranged offset with respect to one another in the direction of the optical axis, and provision being made for an electrostatic retardation apparatus by means of which the energy on impact on the object can be varied, **characterized in that** the distance between the two detectors is between 50 and 75% of the distance between the object-side detector (11, 12) and the focus plane of the objective, and **in that** the electrostatic retardation apparatus can be used to vary the energy of the electrons on impact on the object, from a primary energy above 5 keV down to a lowest primary energy under 200 eV.

2. Particle beam device according to Claim 1, wherein the external diameter of the particle-sensitive area of the source-side detector (13, 15, 16) is greater than the diameter of the central bore of the sample-side detector (11, 12).

3. Particle beam device according to Claim 1 or 2, wherein both detectors have an annular detection area (11, 13), which is arranged symmetrically with respect to the optical axis.

4. Particle beam device according to one of Claims 1-3, wherein the central opening for the passage of the primary beam through the source-side detector (13, 15, 16) is at most one third of the central opening of the object-side detector (11, 12).

5. Particle beam device according to one of Claims 1-4, wherein the source-side detector (13, 15, 16) is embodied as conversion stop (13) with a scintillation detector (15, 16) and wherein the scintillation detector (15, 16) has a suction field for charged particles emerging from the conversion stop (13).

6. Particle beam device according to Claim 5, wherein the conversion stop (13) consists of a material with an atomic number of no more than 20.

7. Particle beam device according to Claim 5 or 6, wherein the conversion stop (13) is held on an adjustment unit (14).

8. Particle beam device according to one of Claims 1-7, wherein, provided for the output signals of both detectors (11, 12, 13, 15, 16), there is a signal processing means (17) which, from the detector signals, generates output signals corresponding to linear combinations of both detector signals, and wherein the coefficients (m, n) of the linear combination can be freely selected by the user.

## Revendications

1. Appareil à faisceau de particules, notamment appareil à faisceau d'électrons avec une source de faisceau (1, 2, 3), une lentille d'objectif (5, 5a, 6) pour la focalisation d'un faisceau de particules sur un échantillon (10) et deux détecteurs (11, 12, 13, 15, 16) disposés entre la source de faisceau et le plan focal de l'objectif (5, 5a, 6) pour les particules (19, 20) rétrodiffusées ou émises par l'objet (10), dans lequel les détecteurs (11, 12, 13, 15, 16) sont disposés de manière mutuellement décalée dans la direction de l'axe optique, et dans lequel un appareillage électrostatique de ralentissement est prévu pour permettre de faire varier l'énergie lors de l'impact sur l'objet, **caractérisé en ce que** la distance entre les deux détecteurs se situe entre 50 et 75% de la distance entre le détecteur (11, 12) du côté de l'objet et le plan focal de l'objectif, et **en ce que** l'appareillage électrostatique de ralentissement permet de faire varier l'énergie des électrons d'une énergie primaire de plus de 5 keV jusqu'à une énergie primaire la plus basse inférieure à 200 eV lors de l'impact sur l'objet.

2. Appareil à faisceau de particules selon la revendication 1, dans lequel le diamètre extérieur de la surface sensible aux particules du détecteur (13, 15, 16) du côté de la source est supérieur au diamètre du perçage central du détecteur (11, 12) du côté de l'échantillon.

3. Appareil à faisceau de particules selon la revendication 1 ou 2, dans lequel les deux détecteurs comportent une surface de détection annulaire (11, 13) disposée symétriquement par rapport à l'axe optique.

4. Appareil à faisceau de particules selon une des revendications 1 à 3, dans lequel l'ouverture centrale pour le passage du faisceau primaire à travers le détecteur (13, 15, 16) du côté de la source représente au maximum un tiers de l'ouverture centrale du détecteur (11, 12) du côté de l'échantillon.

5. Appareil à faisceau de particules selon une des revendications 1 à 4, dans lequel le détecteur (13, 15, 16) du côté de la source est réalisé sous la forme d'un diaphragme de conversion (13) avec un détecteur à scintillation (15, 16), et dans lequel le détecteur à scintillation (15, 16) comporte un champ d'aspiration pour des particules chargées sortant du diaphragme de conversion (13).

6. Appareil à faisceau de particules selon la revendication 5, dans lequel le diaphragme de conversion (13) est constitué d'un matériau dont le numéro atomique est au plus de 20.

7. Appareil à faisceau de particules selon la revendication 5 ou 6, dans lequel le diaphragme de conversion (13) est incorporé à un dispositif d'ajustage (14).

8. Appareil à faisceau de particules selon une des revendications 1 à 7, dans lequel un traitement de signaux (17) est prévu pour les signaux de sortie des deux détecteurs (11, 12, 13, 15, 16) pour générer à partir des signaux des détecteurs, des signaux de sortie correspondant à des combinaisons linéaires des deux signaux des détecteurs, et dans lequel les coefficients (m, n) de la combinaison linéaire peuvent être choisis librement par l'utilisateur.
